(19) **Europäisches Patentamt / European Patent Office / Office européen des brevets**

(11) **EP 4 300 258 B1**

(12) # FASCICULE DE BREVET EUROPEEN

(45) Date de publication et mention de la délivrance du brevet:
**01.10.2025 Bulletin 2025/40**

(21) Numéro de dépôt: **23180544.1**

(22) Date de dépôt: **21.06.2023**

(51) Classification Internationale des Brevets (IPC):
***G06F 1/32*** *(2019.01)*

(52) Classification Coopérative des Brevets (CPC):
**G06F 1/3212**

(54) **PROCÉDÉ DE GESTION D'UN COMPTEUR COMMUNICANT**

VERFAHREN ZUR VERWALTUNG EINES KOMMUNIZIERENDEN ZÄHLERS

METHOD FOR MANAGING A COMMUNICATING METER

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **29.06.2022 FR 2206566**

(43) Date de publication de la demande:
**03.01.2024 Bulletin 2024/01**

(73) Titulaire: **Sagemcom Energy & Telecom SAS**
**92270 Bois-Colombes (FR)**

(72) Inventeurs:
• **ABID, Oussama**
**92500 RUEIL MALMAISON (FR)**

• **SABRAOUI, Abbas**
**92500 RUEIL MALMAISON (FR)**
• **BASTURK, Ahmet Samet**
**92500 RUEIL MALMAISON (FR)**

(74) Mandataire: **Cabinet Le Guen Maillet**
**3, impasse de la Vigie**
**CS 71840**
**35418 Saint-Malo Cedex (FR)**

(56) Documents cités:
| | |
|---|---|
| EP-A1- 3 264 225 | EP-A1- 3 975 202 |
| DE-T5- 112017 004 311 | JP-A- 2004 230 152 |
| US-A1- 2001 054 967 | US-A1- 2003 014 198 |
| US-A1- 2012 047 379 | US-A1- 2014 077 964 |
| US-B1- 10 154 460 | |

## Description

DOMAINE TECHNIQUE

L'invention concerne le domaine des compteurs communicants alimentés par pile et comprenant une unité de mesure et concerne plus particulièrement le domaine de la gestion des compteurs communicants alimentés par pile pour préserver l'intégrité des mesures lorsque la pile arrive en fin de vie.

ETAT DE LA TECHNIQUE ANTERIEURE

D'une manière connue, l'Internet des Objets (IoT, « Internet of Things » en anglais) est en pleine expansion. L'Internet des Objets représente l'extension de l'Internet à des choses et à des lieux du monde physique. Alors que l'Internet ne se prolonge habituellement pas au-delà du monde électronique, l'Internet des Objets représente des échanges d'informations et de données provenant de dispositifs présents dans le monde réel vers l'Internet, comme par exemple pour la collecte de relevés de consommation d'eau ou pour la surveillance à distance de conditions environnementales (température, pression...). L'Internet des Objets est considéré comme la troisième évolution de l'Internet, baptisée Web 3.0. L'Internet des Objets revêt un caractère universel pour désigner des objets connectés aux usages variés, par exemple dans le domaine de la e-santé ou de la domotique.

Une première approche adoptée pour interconnecter des objets, appelés objets communicants (« IoT device » en anglais), dans le cadre de l'Internet des Objets, s'appuie sur un déploiement, maîtrisé par un opérateur, de passerelles de collecte situées sur des points géographiquement hauts. Hors opérations de maintenance, ces passerelles sont fixes et permanentes. On peut par exemple citer sur ce modèle les réseaux SigFox (marque déposée) ou ThingPark (marque déposée). Par exemple, en France, le réseau SigFox (marque déposée) s'appuie sur les points hauts des sites de transmission de TDF (« Télédiffusion De France »). Ces passerelles de collecte communiquent avec les objets communicants grâce à des systèmes de communication radio moyenne ou longue portée (e.g. système LoRa (marque déposée) de la société Semtech). Cette approche s'appuie sur un nombre limité de passerelles de collecte (difficulté de déploiement de nouvelles infrastructures réseau), ainsi que sur un accès montant (« uplink » en anglais) fiable et sécurisé avec un ou plusieurs serveurs de collecte.

Une seconde approche consiste à connecter des objets communicants au travers de passerelles résidentielles. On peut par exemple citer la technologie Energy Gateway. Un système selon la technologie Energy Gateway est composé de deux parties distinctes : d'une part, une passerelle résidentielle et des capteurs périphériques, qui sont hébergés chez le consommateur et qui permettent la collecte d'informations, la transmission de ces informations à un serveur de collecte, ainsi que le contrôle de déclenchement de diverses actions (contrôle de l'enclenchement des radiateurs ou du chauffe-eau par exemple) ; d'autre part, le serveur de collecte qui assure la mise à disposition des informations reçues et la transmission de commandes pour le contrôle de déclenchement de diverses actions. Ce serveur de collecte est accessible via l'Internet. Les technologies radio employées pour communiquer avec les objets communicants selon cette seconde approche sont de relative courte portée (par exemple de type Zigbee (marque déposée), Bluetooth (marque déposée) ou Wi-Fi (marque déposée)) pour desservir une collecte locale restreinte aux objets de l'habitat.

De tels objets communicants comportent typiquement un ou plusieurs capteurs, et sont typiquement alimentés par piles (ou batteries). Une difficulté réside dans la préservation de la durée de vie des piles, et plus particulièrement dans le fait de garantir le fonctionnement des fonctionnalités indispensables de tels objets communicants tout au long de la durée de vie des piles.

Il est souhaitable de pallier ces inconvénients de l'état de la technique. Il est notamment souhaitable de fournir une solution qui permette d'assurer l'intégrité des données stockées et/ou fournies par ces objets communicants lorsque leurs piles arrivent en fin de vie, et ce tout en minimisant le surcoût matériel qu'entraînerait une telle solution. Il convient de noter qu'un surcoût matériel entraîne généralement un encombrement plus important (par exemple, des éléments capacitifs sont plus coûteux et plus encombrants que des transistors ou des résistances).

Ainsi, il est souhaitable de fournir un procédé de gestion d'un objet communicant permettant de garantir la fourniture en énergie électrique de l'objet communicant pendant une durée prédéfinie.

Les objets communicants sont par exemple des compteurs communicants et l'invention permet de prolonger la capacité des piles à fournir de l'énergie électrique au compteur communiquant pendant une durée prédéfinie tout en garantissant des mesures optimales de consommation de fluides (gaz, eau...).

Dans l'état de la technique, on peut mentionner les documents EP 3975202 A1, US10154460 B1, US 2001/054967 A1, US 2014/077964 A1, et US 2003/014198 A1.

EXPOSE DE L'INVENTION

L'invention est définie par les revendications indépendantes.

Modes de réalisation préférés sont définis par les revendications dépendantes .

BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :

[Fig. 1] illustre schématiquement un exemple d'architecture matérielle d'un compteur communicant à pile ;

[Fig. 2] illustre schématiquement un exemple d'architecture matérielle d'une unité de contrôle d'un compteur communicant ; et

[Fig. 3] est un algorigramme d'un procédé de gestion d'un compteur communicant alimenté par pile(s).

## EXPOSE DETAILLE DE MODES DE REALISATION

*Compteur communicant alimenté par pile*

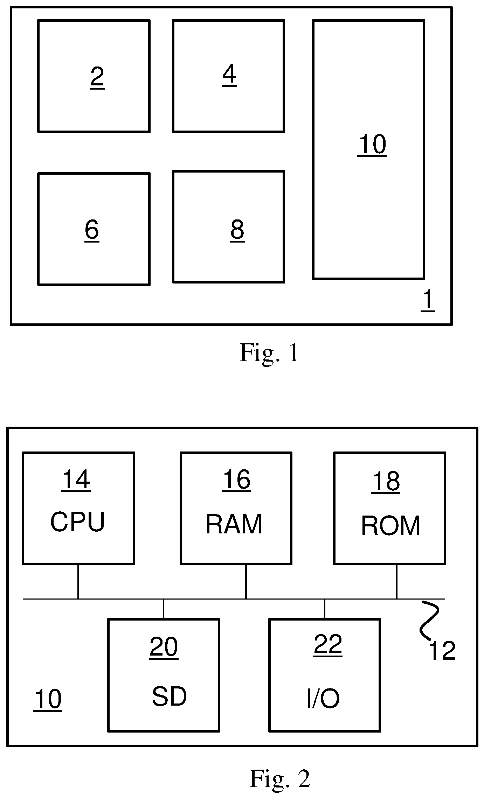

En référence à la Fig. 1, il est proposé un objet communicant alimenté par une pile 2. Il faut entendre le terme « pile » comme étant une unique pile, ou un ensemble de piles fournissant conjointement une source d'énergie électrique autonome.

La présente invention est décrite dans un mode de réalisation particulier où l'objet communicant est un compteur 1 de fluide, c'est-à-dire adapté et configuré pour mesurer une consommation d'un fluide (eau, gaz...). La présente invention est aussi applicable à des objets communicants tels que des capteurs de température, de pression, d'humidité....

Le compteur 1 comprend notamment une unité de mesure 4 pour acquérir des mesures, une unité de communication 6, une unité de signalement 8 pour émettre des signaux d'alarme, et une unité de contrôle 10.

Typiquement, l'unité de mesure 4 peut être adaptée et configurée pour mesurer une consommation d'eau, ou une consommation d'un autre fluide tel que du gaz. A ce titre, l'unité de mesure 4 comprend des moyens connus de mesure (métrologie) et de suivi d'une consommation d'eau.

L'unité de communication 6 comprend un ensemble d'organes de communication permettant la transmission des mesures acquises par l'unité de mesure 4, par exemple à une passerelle de collecte ou à une passerelle résidentielle.

Typiquement, l'unité de communication 6 comprend des organes de communication via un réseau téléphonique, via Internet (protocoles de communication sur IP, via un système LoRa (marque déposée) de la société Semtech, via un système Wi-Fi (marque déposée), via un système de type ZigBee (marque déposée), via un système de type Bluetooth (marque déposée), via un système de réseau étendu à basse consommation LPWAN (« Low Power Wide Area Network » en anglais), ou via un réseau cellulaire dédié à l'Internet des objets de type NB-IOT (« Narrowband Internet Of Things » en anglais) ou de type LTE Cat-M (« Long Term Evolution - Category Machine » en anglais).

Tel que cela sera détaillé ci-après, le compteur 1 au travers de son unité de communication 6 peut privilégier certains canaux de communication en fonction de l'état de charge de la pile 2 et en fonction de la nature des données à transmettre.

L'unité de signalement 8 comprend de la circuiterie électronique pour émettre des signaux d'alarme. Typiquement, l'unité de signalement peut comprendre des organes permettant l'émission de signaux optiques (par exemple, des diodes électroluminescentes). De plus, l'unité de signalement 8 peut transmettre des signaux d'alarme via l'unité de communication 6 pour transmettre les signaux d'alarmes à des unités distantes via des systèmes sans fils comme énoncé précédemment.

L'unité de contrôle 10 comprend de la circuiterie électronique pour piloter et coordonner l'ensemble des unités précédemment citées (unité de mesure 4, unité de communication 6, unité de signalement 8). En outre, l'unité de contrôle 10 est adaptée pour implémenter un procédé de gestion détaillé ci-après.

La Fig. 2 illustre schématiquement un exemple d'architecture matérielle de l'unité de contrôle 10. Selon cet exemple, l'unité de contrôle 10 comporte, reliés par un bus de communication 12 : un processeur ou CPU (« Central Processing Unit » en anglais) 14 ; une mémoire vive RAM (« Random Access Memory » en anglais) 16 ; une mémoire morte ROM (« Read Only Memory » en anglais) 18 ; une unité de stockage ou un lecteur de support de stockage, tel qu'un lecteur de cartes SD (« Secure Digital » en anglais) 20 ; un ensemble d'interfaces 22 permettant à l'unité de contrôle 10 de communiquer avec les autres éléments de l'architecture matérielle présentée ci-dessus en relation avec la Fig. 1.

Le processeur 14 est capable d'exécuter des instructions chargées dans la RAM 16 à partir de la ROM 18, d'une mémoire externe, d'un support de stockage, ou éventuellement d'un réseau de communication. Lorsque l'unité de contrôle 10 est mise sous tension, le processeur 14 est capable de lire de la RAM 16 des instructions et de les exécuter. Ces instructions forment un programme d'ordinateur causant l'implémentation, par le processeur 14, de tout ou partie du procédé de gestion décrit ci-après.

Ainsi, tout ou partie du procédé de gestion décrit ci-après peut être implémenté sous forme logicielle par exécution d'un ensemble d'instructions par une machine programmable, telle qu'un DSP (« Digital Signal Processor » en anglais) ou un microcontrôleur. Tout ou partie des algorithmes et étapes décrits ici peut aussi être implémenté sous forme matérielle par une machine ou un composant dédié, tel qu'un FPGA (« Field-Programmable Gate Array » en anglais) ou un ASIC (« Application-Specific Integrated Circuit » en anglais).

*Procédé de gestion*

Selon un deuxième aspect, il est proposé un procédé 100 de gestion d'un compteur 1 communicant alimenté par pile, pour mesurer une consommation d'un fluide.

Le procédé 100 de gestion distingue trois modes opératoires du compteur 1 : un mode de fonctionnement nominal, un mode de fonctionnement dégradé et un mode de fonctionnement minimal .

Ces différents modes seront détaillés ci-après.

Dans le cas, par exemple, d'un compteur 1 ayant une durée de vie de l'ordre de 10 ans à 20 ans, le procédé 100 peut être exécuté selon une périodicité d'une ou plusieurs semaines.

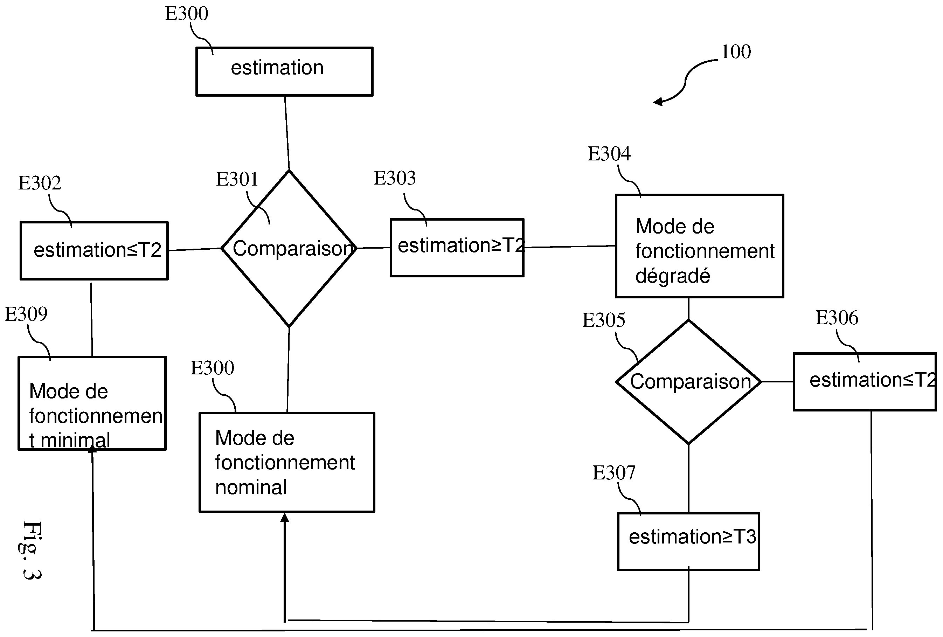

Le procédé 100 de gestion, tel que schématiquement illustré sur la Fig. 3, permet de piloter l'activation et la désactivation de ces trois modes. En d'autres termes, le procédé 100 de gestion permet de piloter le passage du compteur 1 du mode de fonctionnement nominal vers le mode de fonctionnement dégradé, du mode de fonctionnement dégradé vers le mode de fonctionnement minimal, du mode de fonctionnement dégradé vers le mode de fonctionnement nominal, et du mode de fonctionnement minimal vers le mode de fonctionnement nominal.

D'une manière particulièrement astucieuse, le passage d'un mode à l'autre est réalisé en fonction d'une estimation de la capacité restante de la pile 2.

La capacité restante de la pile est une estimation d'une durée pendant laquelle la pile 2 sera apte à alimenter en énergie le compteur. Plus précisément, le procédé de gestion 100 comprend une étape E300 dans laquelle l'unité de contrôle effectue une estimation de la capacité restante de la pile 2 du compteur 1. Typiquement, l'estimation de la capacité restante de la pile 2 peut être effectuée à l'aide d'un coulombmètre utilisant une table associant à chaque mode de fonctionnement du compteur 1 une énergie consommée par unité de temps et en accumulant dans le temps les énergies consommées, ou en réalisant mesure du courant circulant dans la pile 2.

En fonction de l'estimation 108, l'unité de contrôle 10 effectue une étape E301 de comparaison de l'estimation avec deux seuils T1 et T2. Si l'estimation est inférieure ou égale à un premier seuil T1, l'unité de contrôle passe à une étape E303 et commande, à une étape E304, le passage du compteur 1 du mode de fonctionnement nominal vers le mode de fonctionnement dégradé.

Le seuil T1 est déterminé comme proportionnel à une durée prédéfinie Tvie pendant laquelle le compteur 1 doit être alimenté en énergie électrique à laquelle est retranchée la période de temps depuis laquelle le compteur a été mis en service Tserv.

$$T1 = K1*(Tvie-Tserv)$$

Par exemple, la durée prédéfinie est de 5 années et K1 est égal à 80%.

Le seuil T2 est déterminé comme proportionnel à une durée prédéfinie Tvie pendant laquelle le compteur 1 doit être alimenté en énergie électrique à laquelle est retranchée la période de temps depuis laquelle le compteur a été mis en service Tserv.

$$T1 = K2*(Tvie-Tserv)$$

Par exemple la durée prédéfinie est de 5 années et K2 est égal à 50%.

Si l'estimation est inférieure ou égale à un deuxième seuil T2, alors l'unité de contrôle 10 passe à une étape E302 et commande, à une étape E309, le passage du compteur 1 du mode de fonctionnement dégradé vers le mode de fonctionnement minimal.

Il est précisé que le deuxième seuil T2 est inférieur au premier seuil T1.

Tel que cela sera détaillé ci-après, le passage en mode de fonctionnement nominal, en mode de fonctionnement dégradé ou en mode de fonctionnement minimal, impacte la fréquence de mesures et les actions effectuées par le compteur 1.

*Mode de fonctionnement nominal*

En mode de fonctionnement nominal, l'unité de mesure 4 effectue des mesures à une fréquence nominale prédéterminée.

Dans un mode de réalisation particulier, la fréquence nominale est comprise entre 6Hz et 10Hz. Préférentiellement, la fréquence nominale est de 8Hz.

En sus, en mode de fonctionnement nominal, le compteur 1 effectue des actions choisies parmi : transmettre les mesures collectées à une première périodicité prédéterminée, mettre à jour un programme du compteur 1 ou d'au moins une fonctionnalité du compteur 1, autoriser une communication via un organe de communication sans-fil ou optique, transmettre une sauvegarde des mesures à une seconde périodicité prédéterminée, émettre un signal d'alarme de détection d'une anomalie.

Plus précisément, la transmission des mesures collectées à une première périodicité prédéterminée peut, par exemple, être effectuée une fois par jour. Cette transmission peut être effectuée par l'unité de transmission 6 vers un serveur d'un fournisseur de fluide (typiquement un fournisseur d'eau potable dans le cas d'un compteur 1 permettant de mesurer une consommation d'eau).

En mode de fonctionnement nominal, l'action de mettre à jour un programme du compteur 1 peut être réalisée n'importe quand et peut concerner l'ensemble des programmes permettant le fonctionnement du compteur 1. La mise à jour peut être effectuée via l'unité de communication 6. D'une manière préférentielle, les mises à jour sont réalisées selon une méthode dite FOTA (« Firmware Over The Air » en anglais, qui peut se traduire par programme par liaison sans fils).

En mode de fonctionnement nominal, le procédé 100 de gestion autorise l'utilisation de l'ensemble des ports et technologies de l'unité de communication 6.

En mode de fonctionnement nominal, le procédé 100 de gestion permet au compteur 1, par le biais de l'unité de communication 6, de transmettre une sauvegarde des mesures à une seconde périodicité prédéterminée. D'une manière préférentielle, la transmission de sauvegarde des mesures est effectuée une fois par jour. Typiquement, les sauvegardes peuvent être transmises à un serveur contrôlé par un fournisseur de fluide (typiquement un fournisseur d'eau potable dans le cas d'un compteur 1 permettant de mesurer une consommation d'eau).

En mode de fonctionnement nominal, le procédé de gestion permet d'émettre un signal d'alarme de détection d'une anomalie. En mode de fonctionnement nominal, le signal d'alarme de détection d'une anomalie peut concerner une détection d'une fuite de fluide, ou une détection d'une fraude, ou encore, par exemple, une détection de fluide circulant en sens inverse.

En outre, en mode de fonctionnement nominal, le procédé 100 de gestion autorise la transmission, à une quatrième périodicité prédéterminée, de trames de supervisions comprenant des données relatives à la pression du fluide, à la présence du fluide ou à la température du fluide.

*Ordre de priorité*

D'une manière particulièrement astucieuse, le procédé 100 de gestion associe un niveau de priorité à chaque action réalisable par le compteur 1, ce qui définit un ordre de priorité dans les actions réalisables par le compteur 1. L'ordre de priorité permet de modifier ou interrompre successivement les actions, en fonction de l'estimation de la capacité restante de la pile 2.

Ainsi, selon un mode de réalisation, les actions peuvent être priorisées comme suit (de la moins prioritaire à la plus prioritaire) : transmettre une sauvegarde des mesures à une seconde périodicité prédéterminée, autoriser une communication via un organe de communication sans-fil ou optique, émettre un signal d'alarme de détection de fluide circulant en sens inverse ou de détection de présence de fluide, transmettre des trames de supervision, mettre à jour un programme du compteur 1 ou d'au moins une fonctionnalité du compteur 1, transmettre des mesures collectées à la première périodicité prédéterminée, émettre un signal d'alarme de détection d'une fuite de fluide ou d'une fraude.

Il est précisé que la mesure de la consommation du fluide présente l'ordre de priorité le plus important.

*Mode de fonctionnement dégradé*

Comme indiqué précédemment, lorsque l'estimation de capacité restante de la pile 2 est inférieure ou égale à un premier seuil T1, alors le procédé 100 de gestion enclenche le passage du compteur 1 en mode de fonctionnement dégradé.

En mode de fonctionnement dégradé, les actions listées précédemment sont modifiées ou interrompues, préférentiellement en fonction de leur niveau de priorité.

Ainsi, comme schématisé en Fig. 3, si le compteur 1 est en mode de fonctionnement nominal et que l'estimation de la capacité est inférieure ou égale au premier seuil T1, alors le compteur 1 va passer en mode de fonctionnement dégradé. Lors de ce premier passage en mode de fonctionnement dégradé, le compteur 1 va modifier l'action consistant à transmettre une sauvegarde des mesures à la seconde périodicité prédéterminée. En mode de fonctionnement dégradé, cette action est effectuée selon la quatrième périodicité prédéterminée. D'une manière préférentielle, la quatrième périodicité prédéterminée est une fois par semaine.

Ainsi, en passant en mode de fonctionnement dégradé, le compteur 1 va transmettre une sauvegarde des mesures (de consommation de fluide) selon la quatrième périodicité prédéterminée.

Cette modification de périodicité de transmission de sauvegarde des mesures tend à réduire la consommation de la pile 2. L'estimation de la capacité restante de la pile 2 est recalculée et recomparée à l'étape E305 (comparaison) avec les seuils T1 et T2. Si cette estimation demeure inférieure ou égale au premier seuil T1, alors l'action suivante dans la liste de priorisation est modifiée ou interrompue. Préférentiellement, les transmissions sans-fil locales sont suspendues. Cette modification ou interruption tend à réduire la consommation de la pile 2. L'estimation de la capacité restante de la pile 2 est recalculée et recomparée (comparaison) avec les seuils T1 et T2. Si cette estimation demeure inférieure ou égale au premier seuil T1, alors l'action suivante dans la liste de priorisation est modifiée ou interrompue. Préférentiellement, les émissions d'alarme de détection de fluide circulant en sens inverse sont suspendues, et seules les émissions d'alarme de détection de présence de fluide sont maintenues. Cette modification ou interruption tend à réduire la consommation de la pile 2. L'estimation de la capacité restante de la pile 2 est recalculée et recomparée à l'étape E305 avec les seuils T1 et T2. Si cette estimation demeure inférieure ou égale au premier seuil, alors l'action suivante dans la liste de priorisation est modifiée ou interrompue. Préférentiellement, l'action de transmettre des trames de supervisions est interrompue. Cette modification ou interruption tend à réduire la consommation de la pile 2. L'estimation de la capacité restante de la pile 2 est recalculée et recomparée (comparaison) avec les seuils T1 et T2. Si cette estimation demeure inférieure ou égale au premier seuil T1, alors l'action suivante dans la liste de priorisation est modifiée ou interrompue. Préférentiellement, la mise à jour d'un programme du compteur 1 ou d'au moins une fonctionnalité du compteur 1 est modifiée de sorte que seules les mises à jour de l'unité de mesure 4 sont effectuées (ainsi, les mises à jour de l'unité de communication 6, les mises à jour de divers logiciels applicatifs et les mises à jour de divers logiciels de supervision sont temporairement suspendues). Cette modification ou interruption tend à réduire la consommation de la pile 2. L'estimation de la capacité restante de la pile 2 est recalculée et recomparée (comparaison) avec les seuils T1 et T2. Si cette estimation demeure inférieure ou égale au premier seuil T1, alors l'action suivante dans la liste de priorisation est modifiée ou interrompue. Préférentiellement, la transmission des mesures collectées à une première périodicité prédéterminée est modifiée. En mode de fonctionnement dégradé, les mesures sont transmises à une troisième périodicité prédéterminée. Préférentiellement, la troisième périodicité correspond à deux émissions par mois. Cette modification ou interruption tend à réduire la consommation de la pile 2. L'estimation de la capacité restante de la pile 2 est recalculée et recomparée (comparaison) avec les seuils T1 et T2. Si cette estimation demeure inférieure ou égale au premier seuil T1, alors l'action suivante dans la liste de priorisation est modifiée ou interrompue. Préférentiellement, l'émission d'un signal d'alarme de détection d'une fuite ou d'une fraude est modifiée. Préférentiellement, en mode de fonctionnement dégradé, le compteur 1 n'émet plus de signal d'alarme de détection d'une fraude. Cette modification ou interruption tend à réduire la consommation de la pile 2. L'estimation de la capacité restante de la pile 2 est recalculée et recomparée (comparaison) avec les seuils T1 et T2. Si cette estimation demeure inférieure ou égale au premier seuil T1, alors l'action suivante dans la liste de priorisation est modifiée ou interrompue. Préférentiellement, la fréquence de mesure de la consommation de fluide est modifiée. En mode de fonctionnement dégradé, le compteur 1 effectue des mesures à une fréquence dégradée. Dans un mode de réalisation particulier, la fréquence dégradée est comprise entre 1Hz et 3Hz. Préférentiellement, la fréquence dégradée est de 2Hz.

D'une manière particulièrement avantageuse, l'utilisation d'un mode de fonctionnement dégradé dans lequel les actions sont priorisées et dans lequel la fréquence de mesure est modifiée permet de préserver la capacité restante de la pile 2 tout en garantissant une capacité de mesures de la consommation du fluide.

Si l'estimation de la capacité restante de la pile devient supérieure à un troisième seuil T3 prédéterminé, alors le procédé de gestion passe à l'étape E307 et fait passer le compteur du mode de fonctionnement dégradé vers le mode de fonctionnement nominal à l'étape E308. Typiquement, si dans l'environnement d'implantation du compteur 1, les conditions de radio-transmission s'améliorent, alors l'unité de communication 6 consommera moins d'énergie et l'estimation de la capacité restante de la pile 2 pourra augmenter. Le troisième seuil T3 correspond à une hystérésis permettant de s'assurer que l'estimation de la capacité restante de la pile 2 a suffisamment augmenté pour passer du mode de fonctionnement dégradé au mode de fonctionnement nominal (de sorte à éviter un phénomène d'oscillation rapide entre le mode de fonctionnement nominal et le mode de fonctionnement dégradé).

Par exemple, le seuil T3 est déterminé comme proportionnel à une durée prédéfinie Tvie pendant laquelle le compteur 1 doit être alimenté en énergie électrique à laquelle est retranchée la période de temps depuis laquelle le compteur a été mis en service Tserv. T3=K3*(Tvie-Tserv) avec K3= 0,95 ou 1.

En revanche, si l'estimation de la capacité restante de la pile 2 continue de diminuer et devient inférieure à un deuxième seuil T2, alors le procédé de gestion passe à l'étape E306 et fait passer le compteur 1 en mode arrêt à l'étape E309.

*Mode de fonctionnement minimal*

En mode de fonctionnement minimal, seules les mesures de la consommation de fluide sont effectuées. La mesure de la consommation de fluide est effectuée à la fréquence dégradée. Les autres actions réalisables par le compteur 1 sont interrompues.

## Revendications

1. Procédé (100) de gestion d'un compteur (1) communicant alimenté par pile (2), pour mesurer une consommation d'un fluide, le compteur (1) comportant une unité de mesure (4) pour acquérir des mesures de consommation du fluide,

   le compteur (1) disposant de trois modes opératoires :

      - un mode de fonctionnement nominal dans lequel l'unité de mesure (4) effectue des mesures à une fréquence nominale prédéterminée, en mode de fonctionnement nominal le compteur (1) effectue des actions choisies parmi : transmettre les mesures collectées à une première périodicité prédéterminée, mettre à jour un programme du compteur (1) ou d'au moins une fonctionnalité du compteur (1), autoriser une communication via un organe de communication sans fils ou optique, transmettre une sauvegarde des mesures à une seconde périodicité prédéterminée, émettre un signal d'alarme de détection d'une anomalie,
      - un mode de fonctionnement dégradé dans lequel l'unité de mesure (4) effectue des mesures à une fréquence dégradée prédéterminée inférieure à la fréquence nominale, et
      - un mode de fonctionnement minimal dans lequel l'unité de mesure (4) effectue des mesures à la fréquence dégradée prédéterminée,

où une unité de contrôle (10) du compteur (1) effectue les étapes suivantes :

- effectuer une estimation de la capacité restante de la pile (2) du compteur (1) ;
- commander le passage du compteur (1) du mode de fonctionnement nominal vers le mode de fonctionnement dégradé lorsque ladite estimation est inférieure ou égale à un premier seuil, T1, ; et
- commander le passage du compteur (1) du mode de fonctionnement dégradé vers le mode de fonctionnement minimal lorsque ladite estimation est inférieure ou égale à un second seuil, T2,

où en mode de fonctionnement dégradé et en mode de fonctionnement minimal, le compteur (1) obtient un niveau de priorité associé pour chaque action choisie et le compteur (1) modifie ou interrompt l'action selon le niveau de priorité associé à l'action,

où si l'estimation de la capacité restante de la pile devient supérieure à un troisième seuil prédéterminé, alors le compteur passe du mode de fonctionnement dégradé vers le mode de fonctionnement nominal, le troisième seuil, T3, correspondant à une hystérésis permettant de s'assurer que l'estimation de la capacité restante de la pile (2) a suffisamment augmenté pour passer du mode de fonctionnement dégradé au mode de fonctionnement nominal.

2. Procédé (100) selon la revendication 1, dans lequel, en mode de fonctionnement dégradé, le compteur (1) transmet les mesures collectées à une troisième périodicité prédéterminée.

3. Procédé (100) selon l'une quelconque des revendications1 ou 2, dans lequel, en mode de fonctionnement dégradé, le compteur (1) met à jour uniquement un programme de l'unité de mesure (4).

4. Procédé (100) selon l'une quelconque des revendications 1 à 3, dans lequel, en mode de fonctionnement dégradé, le compteur (1) transmet une sauvegarde des mesures à une quatrième périodicité prédéterminée.

5. Procédé (100) selon l'une quelconque des revendications 1 à 4, dans lequel, en mode de fonctionnement dégradé, le compteur (1) autorise uniquement une communication via un organe de communication optique.

6. Procédé (100) selon l'une quelconque des revendications 1 à 5, dans lequel la fréquence nominale est comprise entre 6Hz et 10hz.

7. Procédé (100) selon l'une quelconque des revendications 1 à 6, dans lequel la fréquence dégradée est comprise entre 1Hz et 3Hz.

8. Compteur (1) communicant alimenté par pile (2), pour mesurer une consommation d'un fluide, le compteur (1) comportant une unité de mesure (4) pour acquérir des mesures de consommation du fluide, le compteur (1) disposant se de trois modes opératoires :

- un mode de fonctionnement nominal dans lequel l'unité de mesure (4) effectue des mesures à une fréquence nominale prédéterminée en mode de fonctionnement nominal le compteur (1) effectue des actions choisies parmi : transmettre les mesures collectées à une première périodicité prédéterminée, mettre à jour un programme du compteur (1) ou d'au moins une fonctionnalité du compteur (1), autoriser une communication via un organe de communication sans fils ou optique, transmettre une sauvegarde des mesures à une seconde périodicité prédéterminée, émettre un signal d'alarme de détection d'une anomalie,
- un mode de fonctionnement dégradé dans lequel l'unité de mesure (4) effectue des mesures à une fréquence dégradée prédéterminée inférieure à la fréquence nominale et
- un mode de fonctionnement minimal dans lequel l'unité de mesure (4) effectue des mesures à la fréquence dégradée prédéterminée,

où une unité de contrôle (10) du compteur (1) comporte de la circuiterie électronique configurée pour :

- effectuer une estimation de la capacité restante de la pile (2) du compteur (1) ;
- commander le passage du compteur (1) du mode de fonctionnement nominal (101) vers le mode de fonctionnement dégradé lorsque ladite estimation est inférieure ou égale à un premier seuil (T1) ; et
- commander le passage du compteur (1) du mode de fonctionnement dégradé vers le mode de fonctionnement minimal lorsque ladite estimation est inférieure ou égale à un second seuil (T2),

où en mode de fonctionnement dégradé et en mode de fonctionnement minimal, le compteur (1) obtient un niveau de priorité associé pour chaque action choisie et le compteur (1) modifie ou interrompt l'action selon le niveau de priorité associé à l'action,

- si l'estimation de la capacité restante de la pile devient supérieure à un troisième seuil prédéterminé, le compteur passe du mode de fonctionnement dégradé vers le mode de fonctionnement nominal, le troisième seuil T3 correspondant à une hystérésis permettant de s'assurer que l'estimation de la capacité restante de la pile (2) a suffisamment augmenté pour passer du mode de fonctionnement dégradé au mode de fonctionnement nominal.

9. Produit programme d'ordinateur comprenant des instructions de code de programme pour exécuter le procédé de gestion selon l'une quelconque des revendications 1 à 7, lorsque lesdites instructions sont exécutées par un processeur d'un compteur communicant alimenté par pile selon la revendication 8.

10. Support de stockage non transitoire sur lequel est stocké un programme d'ordinateur comprenant des instructions de code de programme pour exécuter le procédé de gestion selon l'une quelconque des revendications 1 à 7, lorsque lesdites instructions sont lues depuis ledit support de stockage non transitoire et exécutées par un processeur d'un compteur communicant alimenté par pile selon la revendication 8.

**Patentansprüche**

1. Verfahren (100) zur Verwaltung eines von einer Batterie (2) gespeisten intelligenten Zählers (1) zur Messung eines Verbrauchs eines Fluids, wobei der Zähler (1) eine Messeinheit (4) zur Erfassung von Verbrauchsmessungen des Fluids aufweist,

   wobei der Zähler (1) über drei Betriebsarten verfügt:

   - einen Nennbetriebsmodus, wobei die Messeinheit (4) Messungen mit einer vorbestimmten Nennfrequenz durchführt, der Zähler (1) im Nennbetriebsmodus Aktionen durchführt, die aus Folgendem gewählt sind: Übertragen der erfassten Messungen mit einer ersten vorbestimmten Periodizität, Aktualisieren eines Programms des Zählers (1) oder wenigstens einer Funktionalität des Zählers (1), Erlauben einer Kommunikation über ein drahtloses oder optisches Kommunikationsorgan, Übertragen einer Sicherung der Messungen mit einer zweiten vorbestimmten Periodizität, Aussenden eines Anomalieerkennungs-Alarmsignals,
   - einen herabgesetzten Betriebsmodus, wobei die Messeinheit (4) Messungen mit einer vorbestimmten herabgesetzten Frequenz durchführt, die niedriger als die Nennfrequenz ist, und
   - einen Minimalbetriebsmodus, wobei die Messeinheit (4) Messungen mit der vorbestimmten herabgesetzten Frequenz durchführt,

   wobei eine Steuereinheit (10) des Zählers (1) die folgenden Schritte durchführt:

   - Durchführen einer Schätzung der Restkapazität der Batterie (2) des Zählers (1);
   - Steuern des Wechsels des Zählers (1) vom Nennbetriebsmodus zum herabgesetzten Betriebsmodus, wenn die Schätzung kleiner als oder gleich einer ersten Schwelle T1 ist; und
   - Steuern des Wechsels des Zählers (1) vom herabgesetzten Betriebsmodus zum Minimalbetriebsmodus, wenn die Schätzung kleiner als oder gleich einer zweiten Schwelle T2 ist,

   wobei im herabgesetzten Betriebsmodus und im Minimalbetriebsmodus der Zähler (1) ein zugeordnetes Prioritätsniveau für jede gewählte Aktion erhält und der Zähler (1) die Aktion je nach dem Prioritätsniveau, das der Aktion zugeordnet ist, unterbricht,
   wobei, wenn die Schätzung der Restkapazität der Batterie eine dritte vorbestimmte Schwelle überschreitet, der Zähler vom herabgesetzten Betriebsmodus zum Nennbetriebsmodus wechselt, wobei die dritte Schwelle T3 einer Hysterese entspricht, mit der sichergestellt werden kann, dass die Schätzung der Restkapazität der Batterie (2) ausreichend angestiegen ist, um vom herabgesetzten Betriebsmodus zum Nennbetriebsmodus zu wechseln.

2. Verfahren (100) nach Anspruch 1, wobei im herabgesetzten Betriebsmodus der Zähler (1) die erfassten Messungen mit einer dritten vorbestimmten Periodizität überträgt.

3. Verfahren (100) nach einem der Ansprüche 1 oder 2, wobei im herabgesetzten Betriebsmodus der Zähler (1) nur ein Programm der Messeinheit (4) aktualisiert.

4. Verfahren (100) nach einem der Ansprüche 1 bis 3, wobei im herabgesetzten Betriebsmodus der Zähler (1) eine Sicherung der Messungen mit einer vierten vorbestimmten Periodizität überträgt.

5. Verfahren (100) nach einem der Ansprüche 1 bis 4, wobei im herabgesetzten Betriebsmodus der Zähler (1) nur eine Kommunikation über ein optisches Kommunikationsorgan erlaubt.

6. Verfahren (100) nach einem der Ansprüche 1 bis 5, wobei die Nennfrequenz zwischen 6 Hz und 10 Hz liegt.

7. Verfahren (100) nach einem der Ansprüche 1 bis 6, wobei die herabgesetzte Frequenz zwischen 1 Hz und 3 Hz liegt.

8. Intelligenter Zähler (1), der von einer Batterie (2) gespeist wird, zur Messung eines Verbrauchs eines Fluids, wobei der Zähler (1) eine Messeinheit (4) zur Erfassung von Verbrauchsmessungen des Fluids aufweist,

   wobei der Zähler (1) über drei Betriebsarten verfügt:

   - einen Nennbetriebsmodus, wobei die Messeinheit (4) Messungen mit einer vorbestimmten Nennfrequenz durchführt, der Zähler (1) im Nennbetriebsmodus Aktionen durchführt, die aus Folgendem gewählt sind: Übertragen der erfassten Messungen mit einer ersten vorbestimmten Periodizität, Aktualisieren eines Programms des Zählers (1) oder wenigstens einer Funktionalität des Zählers (1), Erlauben einer Kommunikation über ein drahtloses oder optisches Kommunikationsorgan, Übertragen einer Sicherung der Messungen mit einer zweiten vorbestimmten Periodizität, Aussenden eines Anomalieerkennungs-Alarmsignals,
   - einen herabgesetzten Betriebsmodus, wobei die Messeinheit (4) Messungen mit einer vorbestimmten herabgesetzten Frequenz durchführt, die niedriger als die Nennfrequenz ist, und
   - einen Minimalbetriebsmodus, wobei die Messeinheit (4) Messungen mit der vorbestimmten herabgesetzten Frequenz durchführt,

   wobei eine Steuereinheit (10) des Zählers (1) eine elektronische Schaltung aufweist, die für Folgendes ausgebildet ist:

   - Durchführen einer Schätzung der Restkapazität der Batterie (2) des Zählers (1);
   - Steuern des Wechsels des Zählers (1) vom Nennbetriebsmodus (101) zum herabgesetzten Betriebsmodus, wenn die Schätzung kleiner als oder gleich einer ersten Schwelle (T1) ist; und
   - Steuern des Wechsels des Zählers (1) vom herabgesetzten Betriebsmodus zum Minimalbetriebsmodus, wenn die Schätzung kleiner als oder gleich einer zweiten Schwelle (T2) ist,

wobei im herabgesetzten Betriebsmodus und im Minimalbetriebsmodus der Zähler (1) ein zugeordnetes Prioritätsniveau für jede gewählte Aktion erhält und der Zähler (1) die Aktion je nach dem Prioritätsniveau, das der Aktion zugeordnet ist, unterbricht,

   - wenn die Schätzung der Restkapazität der Batterie eine dritte vorbestimmte Schwelle überschreitet, der Zähler vom herabgesetzten Betriebsmodus zum Nennbetriebsmodus wechselt, wobei die dritte Schwelle T3 einer Hysterese entspricht, mit der sichergestellt werden kann, dass die Schätzung der Restkapazität der Batterie (2) ausreichend angestiegen ist, um vom herabgesetzten Betriebsmodus zum Nennbetriebsmodus zu wechseln.

9. Computerprogrammprodukt, das Programmcode-Anweisungen umfasst, um das Verwaltungsverfahren nach einem der Ansprüche 1 bis 7 auszuführen, wenn die Anweisungen von einem Prozessor eines batteriegespeisten intelligenten Zählers nach Anspruch 8 ausgeführt werden.

10. Nichtflüchtiges Speichermedium, auf dem ein Computerprogramm gespeichert ist, das Programmcode-Anweisungen umfasst, um das Verwaltungsverfahren nach einem der Ansprüche 1 bis 7 auszuführen, wenn die Anweisungen aus dem nichtflüchtigen Speichermedium gelesen und von einem Prozessor eines batteriegespeisten intelligenten Zählers nach Anspruch 8 ausgeführt werden.

**Claims**

1. Method (100) for managing a communicating meter (1) supplied by cell (2), for measuring consumption of a fluid, the meter (1) comprising a measurement unit (4) for acquiring measurements of consumption of the fluid,

   the meter (1) having three operating modes available:

   - a nominal operating mode in which the measurement unit (4) makes measurements at a predetermined nominal frequency, in nominal operating mode the meter (1) performs actions selected from: transmitting the collected measurements at a first predetermined periodicity, updating a program of the meter (1) or of at least one functionality of the meter (1), enabling a communication via a wireless or optical communication member, transmitting a backup of the measurements at a second predetermined periodicity, sending an alarm signal for detection of an anomaly.
- a degraded operating mode in which the measurement unit (4) makes measurements at a predetermined degraded frequency lower than the nominal frequency, and
- a minimum operating mode in which the measurement unit (4) makes measurements at a predetermined degraded frequency,

wherein a control unit (10) of the meter (1) performs the following steps:

- making an estimation of the remaining capacity of the cell (2) of the meter (1);
- requesting that the meter (1) passes from the nominal operating mode to the degraded operating mode when said estimation is below or equal to a first threshold, T1; and
- requesting that the meter (1) passes from the degraded operating mode to the minimum operating mode when said estimation is below or equal to a second threshold, T2.

wherein, in degraded operating mode and in minimum operating mode, the meter (1) obtains an associated priority level for each action selected, and the meter (1) modifies or interrupts the action according to the priority level associated with the action, wherein, if the estimation of the remaining capacity of the cell becomes higher than a third predetermined threshold, then the meter passes from the degraded operating mode to the nominal operating mode, the third threshold, T3, corresponding to a hysteresis making it possible to ensure that the estimation of the remaining capacity of the cell (2) has sufficiently increased to pass from the degraded operating mode to the nominal operating mode.

2. Method (100) according to claim 1, wherein, in degraded operating mode, the meter (1) transmits the collected measurements at a third predetermined periodicity.

3. Method (100) according to either one of claims 1 or 2, wherein, in degraded operating mode, the meter (1) updates solely a program of the measurement unit (4).

4. Method (100) according to any one of claims 1 to 3, wherein, in degraded operating mode, the meter (1) transmits a backup of the measurements at a fourth predetermined periodicity.

5. Method (100) according to any one of claims 1 to 4, wherein, in degraded operating mode, the meter (1) enables solely a communication via an optical communication member.

6. Method (100) according to any one of claims 1 to 5, wherein the nominal frequency lies between 6 Hz and 10 Hz.

7. Method (100) according to any one of claims 1 to 6, wherein the degraded frequency lies between 1 Hz and 3 Hz.

8. Communicating meter (1) supplied by cell (2), for measuring consumption of a fluid, the meter (1) comprising a measurement unit (4) for acquiring measurements of consumption of the fluid,

the meter (1) having three operating modes available:

- a nominal operating mode in which the measurement unit (4) makes measurements at a predetermined nominal frequency, in nominal operating mode the meter (1) performs actions selected from: transmitting the collected measurements at a first predetermined periodicity, updating a program of the meter (1) or of at least one functionality of the meter (1), enabling a communication via a wireless or optical communication member, transmitting a backup of the measurements at a second predetermined periodicity, sending an alarm signal for detection of an anomaly.
- a degraded operating mode in which the measurement unit (4) makes measurements at a predetermined degraded frequency lower than the nominal frequency, and
- a minimum operating mode in which the measurement unit (4) makes measurements at a predetermined degraded frequency,

wherein a control unit (10) of the meter (1) comprises electronic circuitry configured for:

- making an estimation of the remaining capacity of the cell (2) of the meter (1);
- requesting that the meter (1) passes from the nominal operating mode (101) to the degraded operating mode when said estimation is below or equal to a first threshold (T1); and

- requesting that the meter (1) passes from the degraded operating mode to the minimum operating mode when said estimation is below or equal to a second threshold (T2), wherein, in degraded operating mode and in minimum operating mode, the meter (1) obtains an associated priority level for each action selected, and the meter (1) modifies or interrupts the action according to the priority level associated with the action,

- if the estimation of the remaining capacity of the cell becomes higher than a third predetermined threshold, the meter passes from the degraded operating mode to the nominal operating mode, the third threshold T3 corresponding to a hysteresis making it possible to ensure that the estimation of the remaining capacity of the cell (2) has sufficiently increased to pass from the degraded operating mode to the nominal operating mode.

9. Computer program product comprising program code instructions for executing the management method according to any one of claims 1 to 7, when said instructions are executed by a processor of a communicating meter supplied by cell according to claim 8.

10. Non-transient storage medium on which a computer program product is stored, comprising program code instructions for executing the management method according to any one of claims 1 to 7, when said instructions are read from said non-transient storage medium and executed by a processor of a communicating meter supplied by cell according to claim 8.

Fig. 1

Fig. 2

Fig. 3

100

E300 estimation

E301 Comparaison

E303 estimation≥T2

E304 Mode de fonctionnement dégradé

E305 Comparaison

E306 estimation≤T2

E307 estimation≥T3

E300 Mode de fonctionnement nominal

E302 estimation≤T2

E309 Mode de fonctionnement minimal

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3975202 A1
- US 10154460 B1
- US 2001054967 A1
- US 2014077964 A1
- US 2003014198 A1